Europäisches Patentamt

European Patent Office

Office européen des brevets

(11) Veröffentlichungsnummer: **0 498 073 A1**

# EUROPÄISCHE PATENTANMELDUNG

(21) Anmeldenummer: **91121757.8**

(22) Anmeldetag: **19.12.91**

(51) Int. Cl.5: **H05K 7/16**

(30) Priorität: **08.02.91 DE 9101442 U**

(43) Veröffentlichungstag der Anmeldung:
**12.08.92 Patentblatt 92/33**

(84) Benannte Vertragsstaaten:
**AT BE CH DE DK ES FR GB GR IT LI LU NL SE**

(71) Anmelder: **THEO BENNING ELEKTROTECHNIK UND ELEKTRONIK GMBH & CO. KG**
**Münsterstrasse 135 - 137 Postfach 63**
**W-4290 Bocholt(DE)**

(72) Erfinder: **Steiner, Otto**
**Richard-Gebhart-Strasse 34**
**A-3423 St. Andrä-Wördern(AT)**

(74) Vertreter: **Patentanwälte Dipl.-Ing. Alex Stenger Dipl.-Ing. Wolfram Watzke Dipl.-Ing. Heinz J. Ring**
**Kaiser-Friedrich-Ring 70**
**W-4000 Düsseldorf 11(DE)**

(54) **Vorrichtung zur Aufnahme mindestens eines Einschubes, insbesondere Stromrichtergerätes.**

(57) Die Erfindung betrifft eine Vorrichtung zur Aufnahme mindestens eines an seiner Rückseite mit Anschlüssen versehenen Einschubes (1), insbesondere Stromrichtergerätes, mit horizontal in der Vorrichtung angeordneten und parallel zueinander verlaufenden Führungen, auf denen aufliegend der Einschub (1) in die Vorrichtung einschiebbar ist. Um eine Vorrichtung zur Aufnahme mindestens eines an seiner Rückseite mit Anschlüssen versehenen Einschubes (1), insbesondere Stromrichtergerätes, so weiterzubilden, daß mit einfachen Mitteln die Handhabung des Einschubes (1) im Rahmen von Arbeiten an dessen Rückseite, insbesondere an den dort vorhandenen Anschlüssen, erleichtert wird, wird vorgeschlagen, daß im Bereich des vorderen Endes der Führungen Halteelemente (10) angeordnet sind und daß im rückwärtigen Bereich der Unterseite (5) des Einschubes (1) Fangelemente (7) befestigt sind, welche bei nahezu vollständig aus der Vorrichtung herausgezogenem Einschub (1) relativ zu den Halteelemten (10) verschwenkbar auf den Halteelementen (10) aufliegen.

Fig. 2

Die Erfindung betrifft eine Vorrichtung zur Aufnahme mindestens eines an seiner Rückseite mit Anschlüssen versehenen Einschubes, insbesondere Stromrichtergerätes, mit horizontal in der Vorrichtung angeordneten und parallel zueinander verlaufenden Führungen, auf denen aufliegend das Stromrichtergerät in die Vorrichtung einschiebbar ist.

Stromrichtergeräte lassen sich in der Regel in Form rechteckiger Einschübe in mehrstöckige Aufnahmevorrichtungen einschieben. Die einzelnen Einschubfächer sind jeweils mit an den Seitenwänden befestigten Führungen versehen, auf denen aufliegend das Stromrichtergerät in die Vorrichtung eingeschoben werden kann. Da sich allerdings sämtliche Anschlüsse, Z.B. Klemmen, des Stromrichtergerätes an dessen Rückseite befinden, müssen vor dem Einschieben des Gerätes diese Anschlüsse mit den entsprechenden Leitungen verbunden werden. Da diese Leitungen in der Regel nicht so lang sind, daß das Stromrichtergerät zur Durchführung der Anschlußarbeiten außerhalb der Vorrichtung abgesetzt werden kann, sind, insbesondere beim Anschluß schwerer Stromrichtergeräte, mindestens zwei Bedienkräfte erforderlich. Während eine Person das Stromrichtergerät festhält, nimmt die andere Person an der Geräterückseite die Anschlußarbeiten vor. Anschließend wird das Gerät in die richtige Stellung vor dem jeweiligen Einschubfach gebracht, auf den Führungen abgesetzt und bis zum Anschlag eingeschoben.

Die beschriebene Arbeitsweise ist nicht nur beim Erstanschluß des Stromrichtergerätes, sondern immer im Rahmen von Arbeiten an der Geräterückseite, zu denen beispielsweise auch Reparatur- und Wartungsarbeiten zählen, erforderlich. In allen diesen Fällen ist es also entweder erforderlich, mit zumindest zwei Personen Bedienungspersonal zu arbeiten, von denen der einen Person einzig die Aufgabe zukommt, das Gleichrichtergerät zu handhaben bzw. festzuhalten. Zur Beseitigung dieser Nachteile kommt zwar grundsätzlich die Möglichkeit in Betracht, vor dem entsprechenden Einschubfach eine Ablage für das Stromrichtergerät anzuordnen, beispielsweise in Form eines höhenverstellbaren Tisches, jedoch handelt es sich hierbei um eine Lösung, deren Aufwand in keinem Verhältnis zu dem erzielten Vorteil steht. Außerdem ermöglicht eine solche Arbeitsweise, anders als eine manuelle Handhabung, keine Absenkung des Einschubes in die Vertikale. Gerade in einer solchen Stellung sind jedoch infolge der nach oben weisenden Geräterückseite Anschluß- und Wartungsarbeiten am besten durchführbar.

Der Erfindung liegt daher die Aufgabe zugrunde, eine Vorrichtung zur Aufnahme mindestens eines an seiner Rückseite mit Anschlüssen versehenen Einschubes, insbesondere Stromrichtergerätes, so weiterzubilden, daß mit einfachen Mitteln die Handhabung des Einschubes im Rahmen von Arbeiten an dessen Rückseite, insbesondere an den dort vorhandenen Anschlüssen, erleichtert wird.

Zur technischen Lösung dieser Aufgabe wird vorgeschlagen, daß im Bereich des vorderen Endes der Führungen Halteelemente angeordnet sind und daß im rückwärtigen Bereich der Unterseite des Einschubes Fangelemente befestigt sind, welche bei nahezu vollständig aus der Vorrichtung herausgezogenem Einschub relativ zu den Halteelementen verschwenkbar auf den Halteelementen aufliegen.

Die erfindungsgemäße Vorrichtung ermöglicht es, den Einschub relativ mühelos in eine solche Lage zu bringen, daß Anschluß- und Wartungsarbeiten an der Rückseite des Einschubes leicht vorgenommen werden können. Hierbei braucht der Einschub nicht extra festgehalten zu werden, denn dieser gelangt beim Herausziehen und anschließenden Absenken von selbst in eine stabile Hängelage, in der sowohl die Rückseite des Einschubes als auch dessen Oberseite frei zugänglich sind.

Diese stabile Hängelage wird erreicht, indem der Einschub soweit aus der Vorrichtung herausgezogen wird, bis Fangelemente des Einschubes in Eingriff mit Halteelementen der Vorrichtung gelangen, worauf der Einschub abgesenkt wird, bis dieser mittels seiner Fangelemente frei in den Halteelementen hängt. Hierbei nimmt der Einschub eine leicht nach vorn geneigte Lage ein, in der sowohl die Rückseite als auch die Oberseite des Einschubes optimal zugänglich sind.

Um den Einschub zurück in das Einschubfach zu befördern, wird dieser an seiner Vorderkante bis in die Waagerechte angehoben und dann, nur an seiner Vorderseite gestützt, in das Einschubfach zurückbewegt.

Die erfindungsgemäße Lösung eignet sich in erster Linie zur leichteren Handhabung von Stromrichtergeräten, da derartige Geräte in der Regel sehr schwer sind, so daß es einer Person alleine nicht möglich ist, sowohl das Stromrichtergerät zu handhaben als auch an dessen Rückseite Anschluß- und Wartungsarbeiten vorzunehmen.

Bei einer Weiterbildung der Vorrichtung ist jeweils eines der beiden Elemente (Halteelement bzw. Fangelement) als Zylinder ausgebildet, dessen Längsachse rechtwinklig zur Längsrichtung der Führungen verläuft. Diese Ausgestaltung hat den Vorteil, daß vorhandene Vorrichtungen mit geringen technischen Mitteln in der erfindungsgemäßen Weise umgerüstet werden können.

Hierbei ist es von Vorteil, wenn das Halteelement als Zylinder und insbesondere als unterhalb der Führung befestigter Zapfen ausgebildet ist.

Der Zapfen, der gemäß einer weiteren Ausgestaltung mit einem freien Ende seitlich unter der Führung herausragt, ist durch Schweißen oder Löten leicht an der Unterseite der Führung befestigbar und kann daher auch bei einer bereits erstellten Vorrichtung leicht nachträglich vorgesehen werden. Umbauarbeiten an der Vorrichtung, insbesondere deren teilweise oder vollständige Demontage, sind hierbei nicht erforderlich.

Der Einschub wird dann besonders sicher gehalten, wenn das Fangelement die Gestalt eines zur Frontseite des Einschubes hin offenen "U" aufweist. Hierbei ergibt sich ein besonders einfacher konstruktiver Aufbau, wenn das U-förmige Fangelement durch ein hakenförmiges Ende einer an der Unterseite des Einschubes angeordneten Fangschiene gebildet ist. Auf diese Weise besteht das Fangelement aus einem einfach und preiswert herstellbaren Biegeteil.

Schließlich wird mit der Erfindung vorgeschlagen, die Fangschiene an der Unterseite des Einschubes zu befestigen. Auf diese Weise ist eine besonders sichere Handhabung des Einschubes möglich, da dieser auch im Falle unsachgemäßer Behandlung nicht versehentlich von der übrigen Vorrichtung getrennt werden kann.

Auf der Zeichnung ist ein Ausführungsbeispiel der erfindungsgemäßen Vorrichtung zur Aufnahme mindestens eines Einschubes dargestellt, und zwar zeigen:

Fig. 1   in einer Ansicht eine Vorrichtung zur Aufnahme mehrerer Stromrichtergeräte in Form von Einschüben;

Fig. 2   einen Schnitt durch die Vorrichtung nach Fig. 1 entlang der Linie II-II mit der zusätzlichen Darstellung eines abgesenkten Stromrichtergerätes;

Fig. 3   in einer Schnittdarstellung ein Stromrichtergerät mit einer darunter befestigbaren Fangschiene über einer Führung und

Fig. 4   eine Ansicht der Fangschiene sowie der Führung der Fig. 3 entlang der Linie IV-IV.

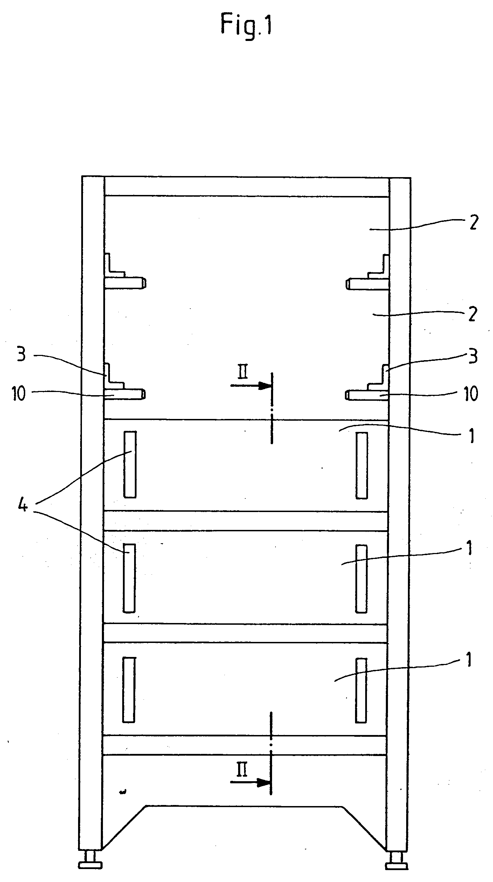

Die in Fig. 1 dargestellte Vorrichtung zur Aufnahme mehrerer Gleichrichtergeräte in Form von Einschüben 1 verfügt über insgesamt fünf übereinanderliegende Einschubfächer 2, von denen nur die unteren drei Einschubfächer 2 mit Gleichrichtergeräten versehen sind, während die beiden oberen Einschubfächer 2 leer sind.

An Seitenwänden der Vorrichtung sind für jedes Einschubfach 2 zwei Führungen 3 in Form L-förmiger Winkel vorgesehen, deren horizontale Schenkel einander zugewandt sind. Die parallel zueinander verlaufenden Führungen 3 jedes Einschubfaches 2 dienen der Führung und Auflage des jeweiligen Einschubes 1.

In der Fig. 1 nicht dargestellt sind Anschlußleitungen zum elektrischen Anschluß der Gleichrichtergeräte. Diese Anschlußleitungen sind durch die Rückwand der Vorrichtung hindurchgeführt und mit Anschlußklemmen an der Rückseite der Gleichrichtergeräte in lösbarer Weise verbunden.

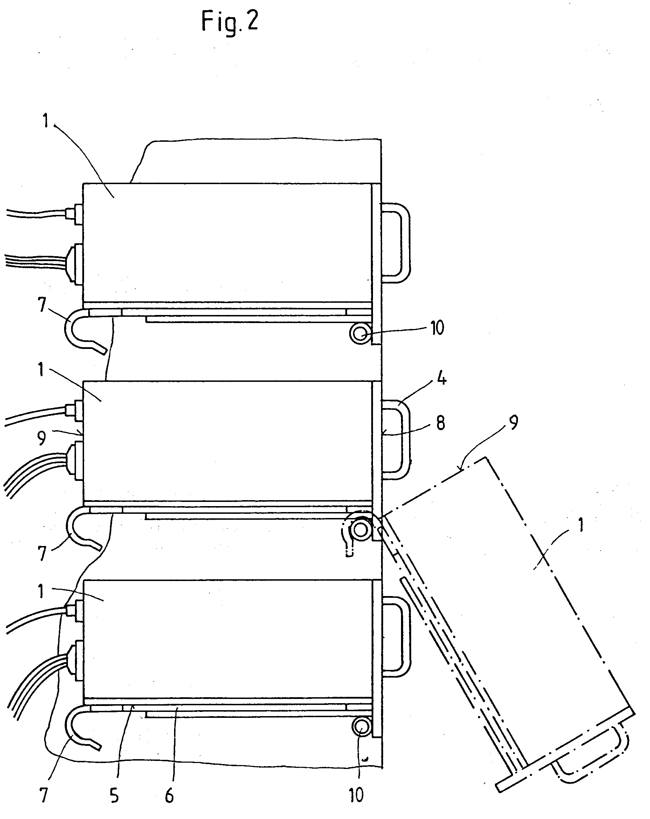

In Fig. 2 ist dargestellt, daß die Gleichrichtergeräte in Form von Einschüben 1 zur leichteren Handhabung frontseitig mit Bügelgriffen 4 versehen sind. Mittels dieser Bügelgriffe 4 lassen sich die Einschübe 1 in horizontaler Richtung aus der Vorrichtung herausziehen, wobei die Einschübe 1 auf den horizontalen Führungen 3 gleiten.

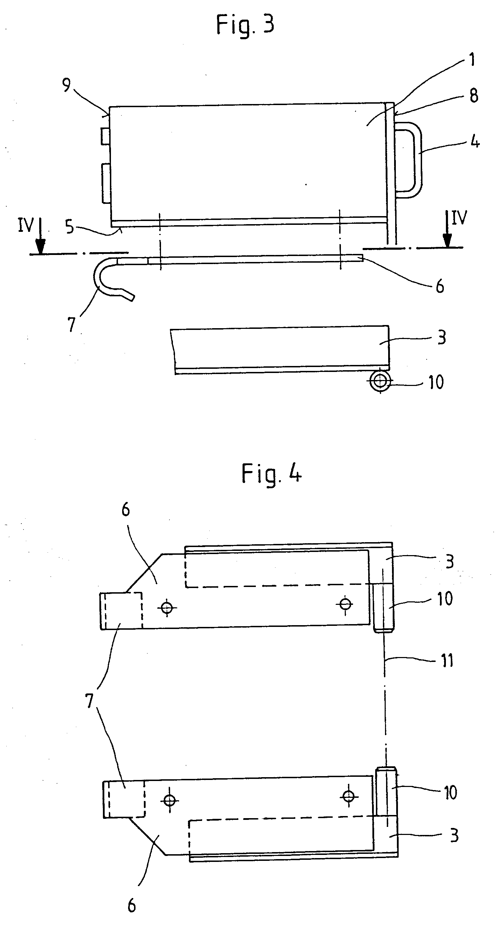

Fig. 2 und insbesondere Fig. 3 lassen erkennen, daß an der Unterseite 5 jedes Einschubes 1 beidseitig jeweils eine Fangschiene 6 mittels Schrauben oder ähnlicher Befestigungselemente befestigt ist. Die Fangschiene 6 verfügt über ein hakenförmiges Ende 7, wobei der Haken in etwa die Form eines zur Frontseite 8 des Einschubes 1 hin offenen "U" aufweist. In Längsrichtung des Einschubes 1 betrachtet befindet sich das hakenförmige Ende noch hinter der Rückseite 9 des Einschubes 1, überragt also noch den hinteren Gehäuseabschluß.

Fig. 3 läßt erkennen, daß der Biegeradius des hakenförmigen Endes 7 der Fangschiene 6 so bemessen ist, daß dieser großer ist als der Durchmesser eines an der Führung 3 befestigten Zapfens 10. Die Lage und Anordnung des Zapfens 10 läßt sich am besten der Fig. 4 entnehmen. Danach besteht der beidseitig vorhandene Zapfen 10 aus einem Zylinder, der durch Schweißen oder Löten so an der Unterseite der Führung 3 befestigt ist, daß die Längsachse 11 des Zapfens 10 rechtwinklig zur Längsrichtung der Führungen 3 verläuft. Beide einem gemeinsamen Einschubfach 2 zugehörenden Zapfen 10 liegen fluchtend zueinander auf der Längsachse 11 und ragen mit etwa der Hälfte ihrer Länge und aufeinander zugerichtet unter den Führungen 3 heraus. In diesem Zusammenhang ist in Fig. 4 dargestellt, daß die Zapfen 10 soweit unter der Führung 3 herausragen, daß sie von dem hakenförmigen Ende 7 der Fangschiene 6 erfaßt werden können, wenn die Fangschiene 6 sich horizontal entlang der Führung 3 nach außen bewegt. Das hakenförmige Ende 7 der Fangschiene 6 sowie der Zapfen 10 befinden sich dabei in einer anderen vertikalen Ebene als die Führung 3 und der darauf gleitende Teil der Fangschiene 6. Auf diese Weise behindert die Führung 3 nicht die horizontale Bewegung des hakenförmigen Endes 7 der Fangschiene 6.

Die Funktionsweise der erfindungsgemäßen Vorrichtung läßt sich am besten der Fig. 2 entnehmen. Wird mittels der Bügelgriffe 4 einer der Einschübe 1 aus der Vorrichtung herausgezogen, so gleitet der Einschub 1 mit den darunter befestigten Fangschienen 6 auf den fest in der Vorrichtung angeordneten Führungen 3, bis das hakenförmige Ende 7 jeder Fangschiene 6 an dem unterhalb des vorderen Endes der Führung 3 befestigten Zapfen 10 anschlägt. Da in dieser Lage eine horizontale Führung des Einschubs 1 nicht mehr vorhanden ist, kann der Einschub 1 in der in Fig. 2 gestrichelt dargestellten Weise abgesenkt werden, bis er sich auf darunterliegenden Teilen der Vorrichtung abstützt. Das hakenförmige Ende 7 der Fangschiene 6 bildet also ein Fangelement, welches während des Absenkens des Einschubes 1 das durch den Zapfen 10 gebildete Halteelement umschließt und sich um dieses Halteelement gelenkartig dreht. Durch die U-förmige Gestalt des hakenförmigen Endes 7 kann der Einschub 1 auch bei Einnahme der in Fig. 2 gestrichelt dargestellten Lage nicht aus der Vorrichtung herausfallen. Andererseits kann durch schräges Anheben des Einschubes 1 aus der in Fig. 2 dargestellten Lage heraus das hakenförmige Ende 7 aus dem Zapfen 10 herausgeschoben werden und auf diese Weise der Einschub 1 der Vorrichtung vollständig entnommen werden, beispielsweise für einen Austausch oder zur Durchführung von Reparaturarbeiten.

Bei dem in den Figuren dargestellten Ausführungsbeispiel der Vorrichtung liegen die Gleichrichtergeräte mit den an ihrer Unterseite 5 befestigten Fangschienen 6 auf den Führungen 3 auf. Selbstverständlich ist es aber auch möglich, daß die Gleichrichtergeräte mit ihren Unterseiten 5 unmittelbar auf den Führungen gleiten.

Nimmt das Gleichrichtergerät in Form des Einschubes 1 die in Fig. 2 gestrichelt dargestellte Lage ein, lassen sich leicht Anschluß- und Wartungsarbeiten an der Rückseite 9 durchführen. Nach Beendigung dieser Arbeiten wird der Einschub 1 wieder bis in die Horizontale geschwenkt und anschließend in dieser Ausrichtung in das Einschubfach 2 zurückbewegt.

**Bezugszeichenliste:**

| 1 | Einschub |
|---|---|
| 2 | Einschubfach |
| 3 | Führung |
| 4 | Bügelgriff |
| 5 | Unterseite |
| 6 | Fangschiene |
| 7 | hakenförmiges Ende |
| 8 | Frontseite |
| 9 | Rückseite |
| 10 | Zapfen |
| 11 | Längsachse |

**Patentansprüche**

1. Vorrichtung zur Aufnahme mindestens eines an seiner Rückseite mit Anschlüssen versehenen Einschubes, insbesondere Stromrichtergerätes, mit horizontal in der Vorrichtung angeordneten und parallel zueinander verlaufenden Führungen, auf denen aufliegend der Einschub in die Vorrichtung einschiebbar ist,
**dadurch gekennzeichnet,**
daß im Bereich des vorderen Endes der Führungen (3) Halteelemente (10) angeordnet sind und daß im rückwärtigen Bereich der Unterseite (5) des Einschubes (1) Fangelemente (7) befestigt sind, welche bei nahezu vollständig aus der Vorrichtung herausgezogenem Einschub (1) relativ zu den Halteelementen (10) verschwenkbar auf den Halteelementen (10) aufliegen.

2. Vorrichtung nach Anspruch 1, dadurch gekennzeichnet, daß eines der beiden Elemente (7,10) (Fangelement (7) bzw. Halteelement (10)) als Zylinder ausgebildet ist, dessen Längsachse (11) rechtwinklig zur Längsrichtung der Führungen (3) verläuft.

3. Vorrichtung nach Anspruch 2, dadurch gekennzeichnet, daß das Halteelement (10) als Zylinder ausgebildet ist.

4. Vorrichtung nach Anspruch 3, dadurch gekennzeichnet, daß der Zylinder als unterhalb der Führung (3) befestigter Zapfen (10) ausgebildet ist.

5. Vorrichtung nach Anspruch 4, dadurch gekennzeichnet, daß der Zapfen (10) mit einem freien Ende seitlich unter der Führung (3) herausragt.

6. Vorrichtung nach Anspruch 3, dadurch gekennzeichnet, daß das Fangelement (7) die Gestalt eines zur Frontseite (8) des Einschubes (1) hin offenen "U" aufweist.

7. Vorrichtung nach Anspruch 6, dadurch gekennzeichnet, daß das U-förmige Fangelement (7) durch ein hakenförmiges Ende einer an der Unterseite (5) des Einschubes (1) angeordneten Fangschiene (6) gebildet ist.

8. Vorrichtung nach Anspruch 7, dadurch gekennzeichnet, daß die Fangschiene (6) an dem Einschub (1) befestigt ist.

# Fig.1

## Fig.2

## Fig. 3

## Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-2 809 085 (HERBERT SCOTT FALL) <br> * das ganze Dokument * <br> --- | 1 | H05K7/16 |
| X | DE-A-3 426 102 (SIEMENS AG) <br> * das ganze Dokument * <br> --- | 1-2 | |
| X | FR-A-2 622 365 (SARL SCLE) <br> * das ganze Dokument * <br> ----- | 1-2 | |

**RECHERCHIERTE SACHGEBIETE (Int. Cl.5)**

H05K

Der vorliegende Recherchenbericht wurde für alle Patentansprüche erstellt

| Recherchenort | Abschlußdatum der Recherche | Prüfer |
|---|---|---|
| DEN HAAG | 07 MAI 1992 | TOUSSAINT F.M.A. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
   ......................................................
& : Mitglied der gleichen Patentfamilie, übereinstimmendes
    Dokument

EPO FORM 1503 03.82 (P0403)